# EUROPEAN PATENT SPECIFICATION

(11) **EP 3 219 504 B1**
(45) Date of publication and mention of the grant of the patent: **25.08.2021**
(21) Application number: 15858988.7
(22) Date of filing: 10.11.2015
(51) Int. Cl.: B41M 1/08, C09D 11/101, B41C 1/10, B41N 1/00, B41M 7/00

(54) **WATERLESS PLANOGRAPHIC PRINTING ORIGINAL PLATE, AND METHOD FOR MANUFACTURING PRINTED MATTER USING WATERLESS PLANOGRAPHIC PRINTING PLATE**
WASSERFREIE FLACHDRUCKORIGINALPLATTE UND VERFAHREN ZUR HERSTELLUNG VON DRUCKSACHEN MIT DER WASSERFREIEN FLACHDRUCKPLATTE
CLICHÉ ORIGINAL D'IMPRESSION À PLAT SANS MOUILLAGE, ET PROCÉDÉ DE FABRICATION D'IMPRIMÉS À L'AIDE DU CLICHÉ D'IMPRESSION À PLAT SANS MOUILLAGE

(30) Priority: 11.11.2014 JP 2014228575; 03.09.2015 JP 2015173516
(43) Date of publication of application: 20.09.2017
(73) Proprietor: Toray Industries, Inc., Tokyo 103-8666 (JP)
(72) Inventor: KUSE, Yasunori, Otsu-shi Shiga 520-8558 (JP); IIHARA, Akihiro, Otsu-shi Shiga 520-8558 (JP); MURASE, Seiichiro, Otsu-shi Shiga 520-8558 (JP)
(74) Representative: Kador & Partner PartG mbB
(86) International application number: PCT/JP2015/081538
(87) International publication number: WO 2016/076286

(56) References cited:
- EP-A1- 2 416 218
- EP-A1- 2 624 053
- JP-A- H1 158 923
- JP-A- H1 158 923
- JP-A- H11 344 804
- JP-A- S60 196 346
- JP-A- 2001 508 001
- JP-A- 2010 131 980
- JP-A- 2012 093 728
- US-A- 3 975 352
- None

## Description

### TECHNICAL FIELD

The present invention relates to a waterless printing plate precursor and a method of producing a printed material using a waterless printing plate by UV printing.

### BACKGROUND ART

As a printing method using a lithographic printing plate, a wet printing method, wherein a thin water layer is formed on the plate surface prior to printing to repel ink, and a waterless printing method, wherein silicone rubber is used instead of water to repel ink, are available.

Oil-based printing using oil-based ink (oxidative polymerization type ink) has been usually employed in both methods. Unfortunately, since drying of oil-based ink is time-consuming, it is necessary to transfer a printed material to a drying space for air drying. Therefore, reduction of production period or delivery period has been limited. In addition, in the case of heat drying that requires a large-scale system, energy cost increases, which is problematic.

For the above reasons, a UV printing method using UV ink wherein ink curing is instantly carried out via UV irradiation has been suggested for wet printing for reduction of delivery period/cost-saving (Patent Document 1). However, it is known that when wet printing is conducted on non-absorbable materials such as plastics sheets and surface-treated papers, preparation of dampening water is more difficult than wet printing on ordinary papers. In addition, UV ink is often used for food packaging, etc. As dampening water is used for wet printing, dampening water components may partially set off from the surface of a printed material to the backside of a printed material placed thereon while the printed materials are stacked for storage. This has been problematic because a food is brought into direct contact with the backside.

Meanwhile, since no dampening water is used for waterless printing, such problem would not occur in principle. The concept of waterless printing is that a component having low polarity such as hydrocarbon in an ink is incorporated into an ink repellent layer in non-imaging areas, the ink repellent layer is pressurized during printing so that the component having low polarity is pushed out, and a liquid film of the component having low polarity is formed on the surface of the ink repellent layer, thereby removing/repelling ink.

Patent Documents 2 and 3 disclose a lithographic printing plate precursor comprising at least a heat sensitive layer and an ink repellent layer which is a silicone rubber layer. The lithographic printing plate precursor is suitable for direct drawing-type waterless lithographic printing.

Patent Document 4 discloses an ink repellent composition containing an oil of low volatility having a surface energy less than 27 dynes/cm and a solid fluorinated polymer such as a polymer-of a fluoroalkyl acrylate. The ink repellent composition is suitable for waterless lithographic printing.

### PRIOR ART REFERENCES

### PATENT DOCUMENTS

Patent Document 1: Japanese Patent Application Laid-Open Publication No. 2011-225751
Patent Document 2: EP-A-2624053
Patent Document 3: EP 2 416 218 A1
Patent Document 4: US 3 975 352 A

### DISCLOSURE OF THE INVENTION

### PROBLEMS TO BE SOLVED BY THE INVENTION

However, in the case of waterless printing, an ink such as UV ink containing a small amount of or no component having low polarity is likely to adhere to non-imaging areas. Therefore, the type of available ink is limited. It is also problematic that when the printing environment temperature increases, ink starts to adhere to non-imaging areas, thereby making impossible to maintain the ink repelling effects.

As measures for removing these drawbacks of the prior art, an object of the present invention is to provide a waterless lithographic printing plate precursor that sufficiently repels ink such as an UV ink, which tends to adhere to non-imaging areas, and maintains its repelling effects, and a printing method using a waterless lithographic printing plate obtained from the waterless lithographic printing plate precursor.

### MEANS FOR SOLVING THE PROBLEMS

The present invention is directed to a lithographic printing plate precursor according to claim 1.

The following are preferable embodiments of the printing plate.
(2) The lithographic printing plate precursor according to that described above, wherein the liquid has a surface tension of from 15 mN/m to 30 mN/m at 25°C.
(3) The lithographic printing plate precursors according to any one of those described above, wherein the heat sensitive layer contains a novolak resin.
(4) The lithographic printing plate precursor according to one described above, wherein the heat sensitive layer contains from 20% by mass to 95% by mass of the novolak resin.
(5) The lithographic printing plate precursors according to any one of those described above, wherein the heat sensitive layer contains an organic complex compound.
(6) The lithographic printing plate precursors according to any one of those described above, wherein the heat sensitive layer contains the novolak resin and the organic complex compound at a mass ratio of from 2 to 6.
(7) The lithographic printing plate precursors according to any one of those described above, which has a plate surface elastic modulus of from 4 MPa to 12 MPa when a load of 1400 N/m² is applied to the surface thereof.
(8) A method of producing a lithographic printing plate, comprising the steps of:
   exposing the lithographic printing plate precursors according to any one of those described above to light based on an image; and
   developing the exposed lithographic printing plate precursor and removing the ink repellent layer.
(9) A method of producing a printed material, comprising the steps of:
   allowing an ink to adhere to the surface of the lithographic printing plate according to any one of those described above; and
   transferring the ink directly or via a blanket to a printing substrate.
(10) The method of producing the printed material according to that described above, further comprising a step of irradiating the ink transferred to the printing substrate with an active energy ray.
   In addition, a method of producing a printed material of the invention and preferable embodiments thereof are described below.
(11) A method of producing a printed material according to (10) described above, comprising irradiating the printing substrate with ultraviolet light,
   wherein the lithographic printing plate comprises the ink repellent layer on a substrate, the ink repellent liquid contained in the ink repellent layer has a surface tension of 30 mN/m or less, and the ink contains from 10% by mass to 50% by mass of a photosensitive component.
(12) The method of producing a printed material according to (11) described above, wherein the liquid is of a silicone material.
(13) The method of producing a printed material according to (11) or (12) described above, wherein the ink repellent layer contains from 10% by mass to 25% by mass of the liquid.
(14) The method of producing a printed material according to any one of (9) to (13) described above, wherein the ink contains from 0.5% by mass to 15% by mass of acrylate ester or methacrylate ester having a linear-chain alkyl group.

### EFFECT OF THE INVENTION

According to the present invention, it is possible to obtain a waterless lithographic printing plate precursor that sufficiently repels ink such as an UV ink, which tends to adhere to non-imaging areas of a waterless lithographic printing plate, and maintains its repelling effects.

### BEST MODE FOR CARRYING OUT THE INVENTION

Next described will be the waterless lithographic printing plate precursor of the invention.

The waterless lithographic printing plate precursor of the invention is a lithographic printing plate precursor comprising a substrate and having at least a heat sensitive layer and an ink repellent layer, which is a silicone rubber layer, the ink repellent layer containing an ink repellent liquid, and the ink repellent liquid having a boiling point of not less than 150°C at 101,3 kPa (1 atmospheric pressure), wherein the ink repellent layer contains the liquid in an amount of from 10% by mass to 30% by mass.

Here, the ink repellent liquid is preferably a liquid that prevents an ink to adhere to the ink repellent layer when the liquid is present on the surface of the ink repellent layer in a state of lacking the liquid. It is considered that the ink repellent liquid prevents the adhesion to the ink repellent layer by forming a thin liquid film covering the surface of the ink repellent layer.

The waterless lithographic printing plate precursor of the invention has a substrate. The precursor has at least a heat sensitive layer and an ink repellent layer on or above the substrate. Either a heat sensitive layer or an ink repellent layer may be disposed close to a substrate. However, it is preferable that a substrate, a heat sensitive layer, and an ink repellent layer be disposed in that order.

Examples of a substrate that is used in the present invention include known papers, metals, glass, and films, which are conventionally used as substrates for printing plates and have few dimensional changes during printing. Specific examples include paper, plastic (e.g., polyethylene, polypropylene, or polystyrene) laminated paper, aluminum (including aluminum alloys), zinc, copper or other such metal sheet, glass plates of soda lime, and quartz, silicon wafer, films of plastics material, for example cellulose acetate, polyethylene terephthalate, polyethylene, polyester, polyamide, polyimide, polystyrene, polypropylene, polycarbonate or polyvinyl acetal, and also paper or plastics film laminated with, or with a vapor deposited coating of, an aforesaid metal. Plastic films may be transparent or opaque. From the viewpoint of ease of proofing, opaque plastic films are preferable.

Among these substrates, aluminum plates have few dimensional changes, and are inexpensive, and therefore are particularly preferable. Again, the polyethylene terephthalate films are also favorable as substrates for short-run printing.

Substrate thickness is not particularly limited. The thickness corresponding to a press used for lithographic printing may be selected.

A heat sensitive layer that can be preferably used in the invention will be described below. It is preferable for a heat sensitive layer to function to convert laser beam used for drawing to heat (light-to-heat conversion) so that at least the surface of the heat sensitive layer is degraded by the generated heat, thereby increasing solubility in a developer or reduction of adhesion to the ink repellent layer. Such heat sensitive layer may contain the following composition.
(A) A composition containing an active hydrogen-containing polymer, a crosslinker, and a light-to-heat converting substance
(B) A composition containing an active hydrogen-containing polymer, an organic complex compound, and a light-to-heat converting substance.

The heat sensitive layer can be prepared by coating and drying a solution or dispersion containing such composition. Drying may be conducted at ordinary temperature or by heating. When the heat sensitive layer prepared above is irradiated with laser beam, the crosslinked structure formed with an active hydrogen-containing polymer and a crosslinker in the composition (A) or the crosslinked structure formed with the polymer and an organic complex compound in the composition (B) is degraded by heat generated from the light-to-heat converting substance.

An example of an active hydrogen-containing polymer preferably used for a heat sensitive layer in the present invention is a polymer with a structural unit having active hydrogen. Examples of a structural unit having active hydrogen include-OH, -SH, -NH₂, -NH-, -CO-NH_{2,} -CO-NH-, -OC(=O)-NH-, -NH-CO-NH-, -CO-OH, -CS-OH, -CO-SH, -CS-SH, -SO₃H, -PO₃H₂, -SO₂-NH₂, -SO₂-NH-, and -CO-CH₂-CO-.

Examples of an active hydrogen-containing polymer that can be used for the compositions (A) and (B) are as follows:
homopolymers or copolymers of carboxyl group-containing monomers such as (meth)acrylate, homopolymers or copolymers of (meth)acrylate ester having a hydroxyl group such as hydroxyethyl(meth)acrylate or 2-hydroxypropyl(meth)acrylate, homopolymers or copolymers of N-alkyl(meth)acrylamide or (meth)acrylamide, homopolymers or copolymers of reactants of amines and (meth)glycidyl acrylate or allyl glycidyl, and homopolymers or copolymers of p-hydroxystyrene or vinyl alcohol, which are homopolymers or copolymers of active hydrogen-containing ethylene-unsaturated monomers (copolymerized monomer components may be other active hydrogen-containing ethylene-unsaturated monomers or active hydrogen-free ethylene-unsaturated monomers).

Another example of a polymer with a structural unit having active hydrogen is a polymer with a structural unit having active hydrogen on the main chain. Examples of such polymer include polyurethanes, polyureas, polyamides, epoxy resins, polyalkylenimines, novolak resins, resole resins, and cellulose derivatives. Of these, two or more polymers may be contained. Of these, alcohol hydroxyl group-, phenol hydroxyl group-, or carboxyl group-containing polymers are preferable, phenol hydroxyl group-containing polymers (e.g., homopolymers or copolymers of p-hydroxystyrene, novolak resins, or resole resins) are more preferable, and novolak resins are further preferable. Examples of novolak resins include phenol novolak resins and cresol novolak resins.

The content of an active hydrogen-containing polymer is preferably 20% by mass or more and more preferably 30% by mass or more in the heat sensitive layer in order to degrade the surface of the heat sensitive layer by heat or cause the heat sensitive layer to be likely to be dissolved in a developer, thereby promoting development. In addition, it is preferably 95% by mass or less and more preferably 80% by mass or less in terms of toughness of the heat sensitive layer.

It is also preferable for the heat sensitive layer to contain active hydrogen-free polymer capable of forming a film (hereafter referred to as "other polymer X") as well as an active hydrogen-containing polymer.

Examples of other polymer X include homopolymers or copolymers of (meth)acrylate esters such as polymethyl(meth)acrylate, polybutyl(meth)acrylate, etc., homopolymers or copolymers of styrene-based monomers such as polystyrene, α-methylstyrene, etc., various synthetic rubbers of isoprene, styrene-butadiene, etc., homopolymers of vinyl esters such as polyvinyl acetate, etc., copolymers of vinyl acetate-vinyl chloride, etc., and various condensate polymers of polyester, polycarbonate, etc.

The total content of other polymers X is preferably 5% by mass or more and more preferably 10% by mass or more in the heat sensitive layer in order to improve coating characteristic of the heat sensitive layer composition solution. In order to achieve highly fine image reproducibility, the total content of other polymers X is preferably 50% by mass or less and more preferably 30% by mass or less with respect to the total solid content of the heat sensitive layer.

An example of a crosslinker contained in the composition (A) in the heat sensitive layer is a multifunctional compound having a plurality of functional groups having reactivity to active hydrogen of the above polymers. Examples of the crosslinker include multifunctional isocyanate, multifunctional blocked isocyanate, multifunctional epoxy compounds, multifunctional (meth)acrylate compounds, multifunctional aldehydes, multifunctional mercapto compounds, multifunctional alkoxysilyl compounds, multifunctional amine compounds, multifunctional carboxylic acids, multifunctional vinyl compounds, multifunctional diazonium salts, multifunctional azide compounds, and hydrazine.

An organic complex compound contained in the composition (B) in the heat sensitive layer comprises a metal and an organic compound. This compound functions as a crosslinker for active hydrogen-containing polymers. The heat sensitive layer may further contain the above crosslinker. Examples of such organic complex compound include organic complex salts in which an organic ligand is coordinate-bonded to a metal, organic inorganic complex salts in which an organic ligand and an inorganic ligand are coordinate-bonded to a metal, and metal alkoxides in which a metal and an organic molecule are covalent-bonded via oxygen. Of these, a metal chelate compound having a donor atom with two or more coordinate groups and forming a ring structure containing a metal atom is preferably used in terms of stability of the organic complex compound itself or stability of the heat sensitive layer composition solution.

Preferable examples of major metals that form an organic complex compound include Al(III), Ti(IV), Mn(II), Mn(III), Fe(II), Fe(III), Co(II), Co(III), Ni(II), Ni(IV), Cu(I), Cu(II), Zn(II), Ge, In, Sn(II), Sn(IV), Zr(IV), and Hf(IV). Al(III) is particularly preferable in that it is effective for the improvement of sensitivity, and Ti(IV) is particularly preferable in that it tends to express resistance to a printing ink or ink washing agent.

Examples of the ligand are compounds having coordinate groups having oxygen, nitrogen, and sulfur as a donor atom. Specific examples of the coordinate group include: as coordinate groups having oxygen as a donor atom, -OH (alcohol, enol and phenol), -COOH (carboxylic acid), >C=O (aldehyde, ketone, quinine), -O-(ether), -COOR (ester; R represents aliphatic or aromatic hydrocarbon), -N=O (nitroso compounds), -NO₂ (nitro compounds), >N-O (N-oxide), -SO₃H (sulfonic acid), -PO₃H₂ (phosphorous acid), etc.; as coordinate groups having nitrogen as a donor atom, -NH₂ (primary amine, hydrazine), >NH (secondary amine, hydrazine), >N- (tertiary amine), -N=N- (azo compounds, heterocyclic compounds), =N-OH (oxime), -NO₂ (nitro compounds), -N=O (nitroso compounds), >C=N- (Schiff base, heterocyclic compounds), >C=NH (aldehyde, ketonimine, enamines), -NCS (isothiocyanato), etc.; and, as coordinate groups having sulfur as a donor atom, -SH (thiol), -S- (thioether), >C=S (thioketone, thioamide), =S- (heterocyclic compounds), -C(=O)-SH, -C(=S)-OH and -C(=S)-SH (thiocarboxylic acid), -SCN (thiocynate), etc.

Among the above organic complex compounds formed with metals and coordinate groups, examples of organic complex compounds that are preferably used include complex compounds of metals Al(III), Ti(IV), Fe(II), Fe(III), Mn(III), Co(II), Co(III), Ni(II), Ni(IV), Cu(I), Cu(II), Zn(II), Ge, In, Sn(II), Sn(IV), Zr(IV), and Hf(IV)with β-diketones, amines, alcohols, and carboxylic acids. Examples of further preferable complex compounds include acetylacetone complexes and acetoacetic acid ester complexes of Al(III), Fe(II), Fe(III), Ti(IV), and Zr(IV).

As specific examples of such compounds, it is possible to cite the following compounds: aluminium tris-(acetylacetonate), aluminium tris-(ethylacetoacetate), aluminium tris(propylacetoacetate), aluminium tris(butylacetoacetate), aluminium tris(hexyl-acetoacetate), aluminium tris(nonylacetoacetate), aluminium tris-(hexafluoropentadionate), aluminium tris-(2,2,6,6-tetramethyl-3,5-heptanedionate), aluminium bis(ethylacetoacetate)mono(acetylacetonate), aluminium bis(acetylacetonate)mono(ethylacetoacetate), aluminium bis(propylacetoacetate)mono(acetylacetonate), aluminium bis(butylacetoacetate)mono(acetylacetonate), aluminium bis(hexylacetoacetate)mono(acetylacetonate), aluminium bis(propylacetoacetate)mono(ethylacetoacetate), aluminium bis(butylacetoacetate)mono(ethylacetoacetate), aluminium bis(hexylacetoacetate)mono(ethylacetoacetate), aluminium bis(nonylacetoacetate)mono(ethylacetoacetate), aluminium dibutoxide mono(acetylacetonate), aluminium diiso-propoxide mono(acetylacetonate), aluminium diiso-propoxide mono(ethylacetoacetate), aluminium-s-butoxide bis(ethylacetoacetate), aluminium di-s-butoxide mono(ethylacetoacetate), aluminium diiso-propoxide mono(-9-octadecenylacetoacetate), titanium triiso-propoxide mono(allylacetoacetate), titanium diiso-propoxide bis(triethanolamine), titanium din-butoxide bis(triethanolamine), titanium diiso-propoxide bis(acetylacetonate), titanium di-n-butoxide bis(acetylacetonate), titanium diiso-propoxide bis(2,2,6,6-(tetramethyl-3,5-heptane-dionate), titanium diiso-propoxide bis(ethylacetoacetate), titanium di-n-butoxide bis(ethylacetoacetate), titanium tri-n-butoxide mono(ethylacetoacetate), titanium triiso-propoxide mono(methacryloxyethylacetoacetate), titanium oxide bis(acetylacetonate), titanium tetra(2-ethyl-3-hydroxyhexyloxide), titanium dihydroxy bis(lactate), titanium(ethylene glycolate)bis(dioctyl phosphate), zirconium di-n-butoxide bis(acetylacetonate), zirconium tetrakis(hexafluoropentanedionate), zirconium tetrakis(trifluoropentanedionate), zirconium tri-n-propoxide mono(methacryloxyethylacetoacetate), zirconium tetrakis(acetylacetonate), zirconium tetrakis(2,2,6,6-tetramethyl-3,5-heptanedionate), triglycolate zirconate, trilactate zirconate, iron (III) acetylacetonate, dibenzoylmethane iron (II), tropolone iron, tristropolono-iron (III), hinokitiol iron, trishinokitiolo-iron (III), acetoacetic acid ester iron (III), iron(III) benzoylacetonate, iron (III) diphenylepropanedionate, ion (III) tetramethylheptanedionate, and iron (III) trifluoropentanedionate. Of these, two or more compounds may be contained.

Such organic complex compound functions as a crosslinker for polymers. The amount thereof is preferably 0.5% by mass or more in the heat sensitive layer. From the point of view of the printing durability of the printing plate, it is preferably 50% by mass or less.

In addition, when a novolak resin is used as a polymer contained in the composition of the heat sensitive layer, the mass ratio of novolak resin : organic complex compound is preferably 2 or more, more preferably 2.5 or more, and further preferably 3 or more in order to achieve highly fine image reproducibility. In addition, the mass ratio of novolak resin : organic complex compound is preferably 6 or less, more preferably 5.5 or less, and further preferably 5 or less so that a crosslinked structure of a novolak resin is densely formed, thereby increasing hardness of the heat sensitive layer. By setting the mass ratio of novolak resin : organic complex compound within the above range, it is possible to further increase hardness of the heat sensitive layer, thereby allowing the ink repellent layer to be deformed when an ink roller applies pressure on the ink repellent layer which is an upper layer during printing. As a result, an ink repellent liquid is likely to come out on the surface of the ink repellent layer, thereby improving ink repellency.

According to the present invention, a light-to-heat converting substance that can be contained in the compositions (A) and (B) of the heat sensitive layer is preferably a light-to-heat converting substance that functions to absorb the laser beam, convert the light energy into atomic/molecular motion energy, and instantly generate heat at 200°C or more on the surface of the heat sensitive layer, thereby degrading the crosslinked structure of the heat sensitive layer by heat. In particular, infrared- or near infrared-absorbing pigments and dyes are preferable. Examples thereof include: black pigments such as carbon black, carbon graphite, aniline black, and cyanine black; green pigments of phthalocyanine and naphthalocyanine; crystal water-containing inorganic compounds; metal powders of iron, copper, chromium, bismuth, magnesium, aluminium, titanium, zirconium, cobalt, vanadium, manganese, and tungsten; sulfides, hydroxydes, silicates, hydrosulfates, phosphates, diamine compounds/complexes, dithiol compounds/complexes, phenolthiol compounds/complexes, and mercaptophenol compounds/complexes of these metals.

In addition, as infrared- or near infrared-absorbing dyes, cyanine dyes, azulenium dyes, squarilium dyes, croconium dyes, azo disperse dyes, bisazostilbene dyes, naphthoquinone dyes, anthraquinone dyes, perylene dyes, phthalocyanine dyes, naphthalocyanine metal complex dyes, polymethine type dyes, dithiolnickel complex dyes, indoaniline metal complex dyes, intermolecular CT dyes, benzothiopyran type spiropyran and nigrosine dyes, which are dyes employed for electronics or for recording, and have a maximum absorption wavelength in the range from 700 nm to 1500 nm, are preferably used.

Amongst these dyes, those having a large molar absorptivity ε are preferably used. Specifically, ε is preferably at least 1 x 10⁴ L/(mol·cm) and more preferably at least 1 x 10⁵ L/(mol·cm). When ε is 1×10⁴L/(mol·cm) or more, initial sensitivity can be further improved. Here, the coefficient is based on active energy ray for irradiation. Specific wavelengths may be 780 nm, 830 nm, or 1064 nm.

Two or more light-to-heat converting substances may be contained. By allowing the ink repellent layer to contain two or more light-to-heat converting substances with different absorption wave-lengths, it is also possible to utilize with two or more types of laser with different emission wavelengths.

Among them, carbon black and infrared- or near infrared-absorbing dyes are preferable in view of light-to-heat conversion rate, economy and handling ease.

The content of these light-to-heat converting substances is preferably from 0.1 to 70% by mass, and more preferably from 0.5 to 40% by mass in the heat sensitive layer. By setting the light-to-heat converting substance content to 0.1% by mass or more, it is possible to further improve sensitivity to laser beam. Meanwhile, when the content is set to 70% by mass or less, high printing durability of the printing plate can be maintained.

In addition, the heat sensitive layer of the waterless lithographic printing plate precursor of the present invention may various additives, if necessary. For instance, the heat sensitive layer may contain a silicone-based surfactant or a fluorochemical surfactant in order to improve application performance. In addition, in order to enhance the adhesion between the heat sensitive layer and the ink repellent layer, the heat sensitive layer may contain a silane coupling agent, or a titanium coupling agent. The contents of these additives may differ depending on intended use; however, it is usually 0.1% by mass to 30% by mass with respect to the total solid content of the heat sensitive layer.

A silicone rubber layer, which may be crosslinked organopolysiloxane, is used for the ink repellent layer of the waterless lithographic printing plate precursor of the present invention. In particular, the silicone rubber layer may be a layer obtained by applying an addition reaction-type silicone rubber layer composition or a condensation reaction-type silicone rubber layer composition, or a layer obtained by applying and drying a solution of such composition.

It is preferable for the addition reaction-type silicone rubber layer composition to contain at least vinyl group-containing organopolysiloxane, an SiH group-containing compound having a plurality of hydrosilyl groups (hereafter referred to as "addition reaction-type crosslinker), and a curing catalyst. Further, addition reaction-type silicone rubber layer composition may contain a reaction inhibitor.

The vinyl group-containing organopolysiloxane has a structure represented by the following general formula (I), and has a vinyl group at the main-chain end or within the main chain. Among these, vinyl group-containing organopolysiloxanes having a vinyl group at the main-chain end are particularly preferable. Of these, two or more compounds may be contained.

-(SiR¹R²-O-)ₙ- (I)

In formula (I), n is an integer of not less than 2. R¹ and R² each represent a saturated or unsaturated hydrocarbon group with 1 to 50 carbon atoms. A hydrocarbon group may have a linear-chain, branched, or cyclic structure, or may have an aromatic ring. R¹ and R² may be the same or different. A plurality of R¹ present in polysiloxane of general formula (I) may be the same or different. In addition, a plurality of R² present in polysiloxane of general formula (I) may be the same or different. It is preferable for R¹ and R² in the general formula (I) to have methyl groups that account for at least 50% of R¹ and R² as a whole, in view of ink repellency of the printing plate. The weight average molecular weight of vinyl group-containing organopolysiloxane is preferably 10,000 to 600,000 in view of handling ease and ink repellency or scratch resistance of the printing plate.

Examples of the SiH group-containing compound include organohydrogen polysiloxane and organic polymers having a diorganohydrogensilyl group. Organohydrogen polysiloxane is preferable. Of these, two or more compounds may be contained.

Organohydrogen polysiloxane may have a linear-chain, cyclic, branched, or web molecular structure. Examples thereof include the following: polymethylhydrogensiloxanes sealed with trimethylsiloxy groups at the molecular chain ends, dimethylsiloxane/methylhydrogensiloxane copolymers sealed with trimethylsiloxy groups at the molecular chain ends, dimethylsiloxane/methylhydrogensiloxane/methylphenylsiloxane copolymers sealed with trimethylsiloxy groups at the molecular chain ends, dimethylpolysiloxanes sealed with dimethylhydrogensiloxy groups at the molecular chain ends, dimethylsiloxane/methylphenylsiloxane copolymers sealed with dimethylhydrogensiloxy groups at the molecular chain ends, and methylphenylpolysiloxanes sealed with dimethylhydrogensiloxy groups at the molecular chain ends; and an organopolysiloxane copolymer comprising a siloxane unit represented by R₃SiO_{1/2}, a siloxane unit represented by R₂HSiO_{1/2}, and a siloxane unit represented by SiO_{4/2}; an organopolysiloxane copolymer comprising a siloxane unit represented by R₂HSiO_{1/2} and a siloxane unit represented by SiO_{4/2}; an organopolysiloxane copolymer comprising a siloxane unit represented by RHSiO_{2/2}, a siloxane unit represented by RSiO_{3/2}, and a siloxane unit represented by HSiO_{3/2}.

Two or more examples of organopolysiloxane described above may be used. In the above formulae, R independently represents a monovalent hydrocarbon other than an alkenyl group, which may be substituted. Examples thereof include: alkyl groups such as a methyl group, an ethyl group, a propyl group, a butyl group, a pentyl group, a hexyl group, and a heptyl group; aryl groups such as a phenyl group, a tolyl group, a xylyl group, and a naphtyl group; aralkyl groups such as a benzil group and a phenetyl group; alkyl halide groups such as a chloromethyl group, 3-chloropropyl group, and 3,3,3-trifluoropropyl group.

Examples of organic polymers having a diorganohydrogensilyl group include the following: oligomers formed via polymerization of: dimethylhydrogensilyl group-containing (meth)acrylic monomers of dimethylhydrogensilyl(meth)acrylate, dimethylhydrogensilylpropyl(meth)acrylate, etc.; and monomers of methyl(meth)acrylate, ethyl(meth)acrylate, butyl(meth)acrylate, ethylhexyl(meth)acrylate, lauryl(meth)acrylate, styrene, α-methylstyrene, maleic acid, vinyl acetate, allyl acetate, etc.

The content of the SiH group-containing compound is preferably 0.5% by mass or more and more preferably 1% by mass or more in the silicone rubber layer composition in view of hardenability required for silicone rubber layer formation. In addition, in terms of the ease of controlling the curing rate, the content is preferably 20% by mass or less and more preferably 15% by mass or less.

Examples of the reaction inhibitor include nitrogen-containing compounds, phosphorus-based compounds, unsaturated alcohols, etc. Acetylene group-containing alcohols are preferably used. Of these, two or more compounds may be contained. It is possible to adjust the rate of curing of the silicone rubber layer by adding such reaction inhibitors. The content of the reaction inhibitor is preferably 0.01% by mass or more and more preferably 0.1% by mass or more in the silicone rubber layer composition in view of stability of the silicone rubber layer composition or a solution thereof. In addition, the content is preferably 20% by mass or less and more preferably 15% by mass or less in the silicone rubber layer composition in view of hardenability of the silicone rubber layer.

A curing catalyst can be selected from among known curing catalysts. Platinum-based compounds are preferable. Specific examples include platinum, platinum chloride, chloroplatinic acid, olefin coordinated platinum, alcohol modified complex of platinum, and methylvinyl polysiloxane complex of platinum. Two or more platinum-based compounds may be contained. The content of the curing catalyst is preferably 0.001% by mass or more and more preferably 0.01% by mass or more in the silicone rubber layer composition in view of hardenability of the silicone rubber layer. In addition, the content is preferably 20% by mass or less and more preferably 15% by mass or less in the silicone rubber layer composition in view of stability of the silicone rubber layer composition or a solution thereof.

In addition to the aforementioned compounds, the ink repellent layer may also contain a hydroxyl group-containing organopolysiloxane or hydrolyzable functional group-containing silane or the functional group-containing siloxane, and a known filler such as silica for improving the rubber strength, and a known silane coupling agent for improving the adhesion. Preferable silane coupling agents include alkoxysilanes, acetoxysilanes, and ketoximinosilanes. Particularly, a coupling agent having a vinyl group or an allyl group which is directly bound to a silicon atom is preferable.

It is preferable for the condensation reaction-type silicone rubber layer composition to contain, as materials, at least hydroxyl group-containing organopolysiloxane, a crosslinker, and a curing catalyst.

The hydroxyl group-containing organopolysiloxane has a structure represented by the general formula (I), and have a hydroxyl group at the main-chain end and/or in the main chain. A hydroxyl group-containing organopolysiloxane, which has a hydroxyl group at the main-chain end, is particularly preferable. Of these, two or more compounds may be contained.

Examples of the crosslinker contained in the condensation reaction-type silicone rubber layer composition include, for example, de-acetic-acid type, deoxime type, de-alcohol type, de-acetone type, de-amide type, and de-hydroxylamine type silicon compounds represented by the following formula (II).

(R³)₄₋ₘSiXₘ (II)

In the formula, m represents an integer of 2 to 4; R³ may be the same or different and represents a substituted or non-substituted alkyl group with 1 or more carbon atoms, alkenyl group, aryl group, or a group formed by combining the foregoing groups). X may be the same or a different hydrolyzable group. Examples of hydrolyzable groups include: acyloxy groups such as an acetoxy group; ketoxime groups such as a methylethylketoxime group; alkoxy groups such as a methoxy group, an ethoxy group, a propoxy group, and a butoxy group; alkenyloxy groups such as an isopropenoxy group; acylalkylamino groups such as an acetylethylamino group; and aminooxy groups such as a dimethylaminooxy group. In the foregoing formula, it is preferable that the number m of the hydrolyzable groups is 3 or 4.

Specific compounds include the following compounds:
acetoxysilanes such as methyltriacetoxysilane, ethyltriacetoxysilane, vinyltriacetoxysilane, allyltriacetoxysilane, phenyltriacetoxysilane, and tetraacetoxysilane; ketomiximinosilanes such as vinylmethylbis(methylethylketoximino)silane, methyltris(methylethylketomiximino)silane, ethyltris(methylethylketomiximino)silane, vinyltris(methylethylketoximino)silane, allyltris(methylethylketomiximino)silane, phenyltris(methylethylketomiximino)silane, and tetrakis(methylethylketomiximino)silane; alkoxysilanes such as methyltrimethoxysilane, methyltriethoxysilane, ethyltrimethoxysilane, ethyltriethoxysilane, tetraethoxysilane, tetrapropoxysilane, vinyltrimethoxysilane, vinyltriethoxysilane, allyltriethoxysilane, and vinyltriisopropoxysilane; alkenyloxysilanes such as vinyltrisisopropenoxysilane, diisopropenoxydimethylsilane, and triisopropenoxymethylsilane; and tetraallyloxysilane.

Among these compounds, acetoxysilanes or ketoximinosilanes are preferable in view of the curing rate of the silicone rubber layer, handling ease, etc. Of these, two or more compounds may be contained.

When the above crosslinker is mixed with hydroxyl group-containing organopolysiloxane, the crosslinker reacts with a silanol group. As a result, the silanol group is replaced by the crosslinker, which may results in organopolysiloxane to which the crosslinker is bound. Therefore, in some cases, the silicone rubber composition contains organopolysiloxane to which the crosslinker is bound but not organopolysiloxane containing a silanol group.

The amount of the crosslinker added to the condensation reaction-type silicone rubber layer composition is preferably 0.5% by mass or more and more preferably 1% by mass or more in view of stability of the silicone rubber layer composition or a solution thereof. In addition, the amount is preferably 20% by mass or less and more preferably 15% by mass or less in the silicone rubber layer composition in view of strength of the silicone rubber layer or scratch resistance of the printing plate.

Examples of the curing catalyst contained in the condensation reaction-type silicone rubber layer composition include organic carboxylic acids, acids, alkali, amine, metal alkoxide, metal diketonate, and organic metal salts of tin, lead, zinc, iron, cobalt, calcium, and manganese. Specific examples thereof include dibutyltin diacetate, dibutyltin dioctate, dibutyltin dilaurate, zinc octylate, and iron octylate. Of these, two or more compounds may be contained.

The content of the curing catalyst in the condensation reaction-type silicone rubber layer composition is preferably 0.001% by mass or more and more preferably 0.01% by mass or more in the silicone rubber layer composition in view of hardenability and adhesion of the silicone rubber layer. In addition, the content is preferably 15% by mass or less and more preferably 10% by mass or less in the silicone rubber layer composition in view of stability of the silicone rubber layer composition or a solution thereof.

The ink repellent layer of the waterless lithographic printing plate precursor of the present invention contains an ink repellent liquid for the purpose of improving ink repellency. The boiling point of this liquid at 101,3 kPa (1 atmospheric pressure) is 150°C or more. When the plate surface is pressurized during printing, the ink repellent liquid comes out to the surface of the ink repellent layer, which facilitates ink to fall off. Thus, ink repellency is improved. When the boiling point is 150°C or more, the ink repellent layer is unlikely to volatilize during the production of the waterless lithographic printing plate precursor so that the ink repelling effects obtained with the addition of this liquid will not be lost. The boiling point mentioned herein is defined as a temperature at which a decrease in mass after static placement for 1 hour in an environment at 1 atmospheric pressure is 0.5% by mass or more. In other words, the liquid has a decrease in mass after static placement for 1 hour in an environment at 150°C and 1 atmospheric pressure, which is less than 0.5% by mass. If this is the case, the ink repelling effects obtained with the addition of this liquid will not be lost.

In addition, the surface tension at 25°C of the ink repellent liquid is preferably 15 mN/m to 30 mN/m. If the surface tension is 15 mN/m or more, affinity with other ink repellent layer components is improved, thereby increasing stability of the solution of the ink repellent layer composition. If the surface tension is 30 mN/m or less, ink becomes prone to fall off, thereby further improving ink repellency.

The content of the ink repellent liquid in the ink repellent layer is 10% by mass or more so that the ink repellent liquid is allowed to sufficiently come out to the surface of the ink repellent layer, thereby remarkably improving ink repellency. In addition, in order to maintain the film strength of the ink repellent layer, the content of the ink repellent liquid is 30% by mass or less and preferably 25% by mass or less.

The ink repellent liquid contains preferably a silicone material and more preferably silicone oil. The term "silicone oil" used herein refers to a free polysiloxane component which is not involved in crosslinkage in the ink repellent layer. Accordingly, examples thereof include: dimethyl silicone oils of terminaldimethyl polydimethylsiloxane, cyclic polydimethylsiloxane, terminal-dimethyl-polydimethyl-polymethilphenylsiloxane copolymer, and terminal-dimethyl-polydimethyl-polydiphenylsiloxane copolymer; or denatured silicone oils, in which various organic groups are introduced into a part of an intramolecular methyl group, such as alkyl-modified silicone oil, fluorine-modified silicone oil, polyether-modified silicone oil, alcohol-modified silicone oil, amino-modified silicone oil, epoxy-modified silicone oil, epoxypolyether-modified silicone oil, phenol-modified silicone oil, carboxy-modified silicone oil, mercapto-modified silicone oil, amide-modified silicone oil, carnauba-modified silicone oil, higher fatty acid-modified silicone oil.

The molecular weights of these silicone oils can be determined by gel permeation chromatography (GPC) with the use of polystyrene as an authentic preparation. Silicone oils having a weight average molecular weight Mw of 1,000 to 100,000 are preferable.

The plate surface elastic modulus of the waterless lithographic printing plate precursor of the present invention is preferably 4 MPa to 12 MPa. The plate surface elastic modulus is obtained by pushing a conical diamond indenter into the surface of the ink repellent layer of the printing plate precursor by nanoindentation, and creating a load-indentation depth diagram, thereby calculating the elastic modulus with respect to a load. The plate surface elastic modulus is defined as an elastic modulus when a load of 1400N/m² is applied to the surface of the printing plate precursor. Details of the determination method will be described in the Examples below.

The plate surface elastic modulus is preferably 4 MPa or more, more preferably 5 MPa or more, and further preferably 7 MPa or more so that the film strength of the ink repellent layer is improved and plate wear is increased. In addition, the plate surface elastic modulus is preferably 12 MPa or less so as to improve leaching of the ink repellent liquid into the surface of the ink repellent layer, re-incorporation of the ink repellent liquid into the ink repellent layer, or incorporation of the liquid components in ink into the surface of the ink repellent layer, thereby maintaining ink repellency. The plate surface elastic modulus is further preferably 11 MPa or less and yet further preferably 10 MPa or less. In particular, when the plate surface elastic modulus is set to 10 MPa or less, ink repellency is remarkably improved.

The waterless lithographic printing plate precursor of the present invention may have a protective film and/or interleaving paper on the surface of the ink repellent layer for the purpose of protecting the ink repellent layer.

As the protective film, a film having a thickness of 100 µm or less at which light with a wavelength of an exposure light source sufficiently permeates the film. Typical examples of materials for the protective film include polyethylene, polypropylene, polyvinyl chloride, polyethylene terephthalate, and cellophane. In addition, various light-absorbing agents, photochromic substances, and photobleaching substances disclosed in Japanese Patent No. 2938886 may be present on the protective film for the purpose of preventing sensitization of the plate precursor due to light exposure

As the interleaving paper, an interleaving paper having a weight per square meter of 30 to 120 g/m² is preferable, and an interleaving paper having a weight per square meter of 30 to 90 g/m² is more preferable. When the weight per square meter is 30 g/m² or more, sufficient mechanical strength is achieved. When it is 120 g/m² or less, it is economically advantageous, and it is also advantageous in terms of workability because a layered product of the waterless lithographic printing plate precursor and a paper can be thinned. Examples of interleaving paper that can be preferably used include, but are not limited to, printing media (40 g/m²; Nagoya Pulp Corporation), metal interleaving paper (30 g/m²; Nagoya Pulp Corporation), unbleached kraft paper (50 g/m²; Chuetsu Pulp & Paper Co., Ltd.), NIP paper (52 g/m² Chuetsu Pulp & Paper Co., Ltd.) pure white rolled paper (45 g/m²; Oji Paper Co., Ltd.), Clupack paper (73 g/m²; Oji Paper Co., Ltd.).

A method of producing a waterless lithographic printing plate from the waterless lithographic printing plate precursor of the invention will be described below. The method for producing a waterless lithographic printing plate includes a step of exposing the waterless lithographic printing plate precursor in accordance with an image (light exposure step) and a step of applying physical stimulations to the exposed lithographic printing plate precursor to remove the ink repellent layer in exposed regions (development step).

Firstly, the exposure step will be described. The waterless lithographic printing plate precursor is exposed to light in accordance with an image. When the waterless lithographic printing plate precursor has a protective film, light exposure may be conducted on the protective film or after removal of the protective film. The laser beam sources used in the exposure step are laser beam sources whose emission wavelength region is within the range of 300 nm to 1500 nm. Among them, semiconductor lasers and YAG lasers whose emission wavelength regions are adjacent to the near-infrared region are preferably used as the regions are widely used as regions having the absorption wavelength of the heat sensitive layer. Specifically, laser beam having a wavelength of 780 nm, 830 nm, and 1064 nm is preferably used in view of the light-to-heat conversion efficiency.

Secondly, the development step will be described. Physical stimulations are applied to the exposed lithographic printing plate precursor to remove the ink repellent layer in exposed regions. Examples of a method for applying physical stimulations include: (i) a method wherein the plate surface is wiped off with nonwoven fabric, absorbent cotton, cloth, or sponge impregnated with a developer; (ii) a method wherein the plate surface is pretreated with a developer and then rubbed with a rotary brush during showering with tap water; and (iii) a method wherein high-pressure water, warm water, or steam is injected to the plate surface.

Prior to development, pretreatment may be conducted in a manner such that the plate is immersed in a pretreatment liquid for a certain period of time. As the pre-treatment liquid, it is possible to use, for example, water, a liquid obtained by adding a polar solvent, such as an alcohol, a ketone, an ester, or a carboxylic acid into water, or a liquid obtained by adding a polar solvent into a solvent made up of at least one selected from aliphatic hydrocarbons, aromatic hydrocarbons, etc., or use a polar solvent. Furthermore, a known surfactant may be to the above developer composition. A preferable surfactant has pH of 5-8 in the form of an aqueous solution in terms of safety, disposal cost, etc. The content of the surfactant is preferably 10% by mass or less with respect to the amount of the developer. Such developer is highly safe and economically preferable in terms of disposal cost, etc. It is preferable that a glycol compound or a glycol ether compound be used as a major component. It is more preferable that an amine compound coexist.

As the developer, for example, water, alcohol, or a paraffin type hydrocarbon compound can be used. In addition, a mixture of a propylene glycol derivative such as propylene glycol, dipropylene glycol, triethylene glycol, polypropylene glycol, or alkylene oxide-added polypropylene glycol and water also can be used. Specific examples of the developer include HP-7N and WH-3 (Toray Industries, Inc.) An example of the pre-treatment liquid that can be used is a pre-treatment liquid containing polyethylene ether diol and two or more primary amino groups disclosed in Japanese Patent No. 4839987. Specific examples of the pre-treatment liquid include PP-1, PP-3, PP-F, PP-FII, PTS-1, CP-1, CP-Y, NP-1, and DP-1 (each produced by Toray Industries, Inc.). In addition, in order to increase visibility of imaging areas and measurement precision of halftone dots, it is also possible to add dyes such as Crystal Violet, Victoria Pure Blue, or Astrazon Red to the pre-treatment liquid or developer so as to dye an ink accepting layer in each imaging area upon development. Further, it is also possible to perform dyeing using a liquid, to which the above dye has been added, after development.

A part of or all of the above development step can be conducted automatically by an automatic processor. As an automatic processor, the following systems can be used: a system consisting of a development section, a system in which a pre-treatment section and a development section are installed in that order, a system in which a pre-treatment section, a development section, and a post-treatment section are installed in that order, a system in which a pre-treatment section, a development section, a post-treatment section, and a rinsing section are installed in that order, etc. Specific examples of such automatic processor include TWL-650 series, TWL-860 series, TWL-1160 series (each produced by Toray Industries, Inc.) and an automatic processor disclosed in Japanese Patent Application Laid-Open Publication No. HEI5-6000, in which a stand has a curved recess in order to prevent scratching. These examples may be used in combination.

It is preferable to insert an interleaving paper between plates for the purpose of plate surface protection in order to prepare for a case in which developed waterless lithographic printing plates are stacked for storage.

Next, a method of producing a printed material from the waterless lithographic printing plate of the invention will be described. A waterless lithographic printing plate is a lithographic printing plate which allows printing without dampening water. A heat sensitive layer-derived layer forms an ink accepting layer, which results in an imaging area. An ink repellent layer forms a non-imaging area. It can be said that the ink accepting layer and the ink repellent layer exist on the substantially same plane only with a micron-order difference in level. After inking is completed only in imaging areas by making use of a difference in ink adhesiveness, an ink is transferred to a printing substrate for printing. The term "printing substrate" refers to general printing media including thin paper, thick paper, film, and label, which are not particularly limited. In addition, an ink may be transferred from a printing plate to a printing substrate directly or via a blanket.

An ink curable with an active energy ray can be used for printing with the waterless lithographic printing plate of the invention. As long as such ink is an ink curable with ultraviolet light (hereafter referred to as UV ink), the ink may usually contain photosensitive components that allow a polymerization reaction by ultraviolet light, such as, a reactive monomer or a reactive oligomer, a photopolymerization initiator, and if necessary, a sensitizer. It is preferable that the ink contain 10% by mass to 50% by mass of photosensitive components for UV printing using a waterless lithographic printing plate. When the mass is small, the curing rate is decelerated. In such case, printing substrates containing insufficiently cured UV ink are stacked, which tends to cause offset. Meanwhile, as the proportion of photosensitive components increases, ink repellency decreases, and when the mass thereof increases, ink residues tend to remain in non-imaging areas.

In addition, an UV ink containing acrylate ester or methacrylate ester having a linear-chain alkyl group may be used for the purpose of improving ink repellency. An alkyl group having 9 or more carbon atoms is preferable. Specific examples of acrylate ester having a linear-chain alkyl group include nonyl acrylate, decyl acrylate, undecyl acrylate, dodecyl acrylate, tridecyl acrylate, tetradecyl acrylate, pentadecyl acrylate, hexadecyl acrylate, heptadecyl acrylate, octadecyl acrylate, and isooctadecyl acrylate. Specific examples of methacrylate ester having a linear-chain alkyl group include nonyl methacrylate, decyl methacrylate, undecyl methacrylate, dodecyl methacrylate, tridecyl methacrylate, tetradecyl methacrylate, pentadecyl methacrylate, hexadecyl methacrylate, heptadecyl methacrylate, and octadecyl methacrylate.

The content of acrylate ester or methacrylate ester having a linear-chain alkyl group is preferably 0.5% by mass or more and more preferably 1% by mass or more with respect to the total amount of UV ink in order to improve ink repellency. In addition, it is preferably 15% by mass or less and more preferably 10% by mass or less in order to promote hardenability of UV ink.

As an active energy ray with which UV ink is irradiated may be any active energy ray as long as it has excitation energy necessary for curing reaction. For example, ultraviolet light or an electron beam is preferably used. When curing is attained by an electron beam, an electron beam irradiation system capable of emitting an electron beam of 100 to 500 eV is preferably used. When curing is attained by ultraviolet light, an ultraviolet light irradiation system such as a high-pressure mercury lamp, a xenon lamp, a metal halide lamp, or LED can be used but it is not particularly limited to such examples.

In the case of UV ink that is cured with ultraviolet light, curing can be carried out preferably within 2 seconds and more preferably within 1 second under general printing conditions although it depends on the rate of printing of a press and intensity/irradiation area of a light source. If curing can be carried out by ultraviolet light irradiation within 2 seconds, the drying step can be shortened because of no offset, and if curing can be carried out within 1 second, the drying step can be further shortened.

Ink repellency of a printing plate can be evaluated by measuring the scumming start temperature for printing using a waterless lithographic printing plate. The term "scumming" refers to a state in which an ink remains in a non-imaging area of a printing plate, thereby causing the ink to be transferred to an area of a printing substrate where adhesion of ink is not originally intended. In the case of waterless printing, as the plate surface temperature increases, scumming tends to occur. Stable printing can be realized without scumming. The plate surface temperature at which scumming starts is referred to as "scumming start temperature." As this temperature increases, printing becomes easier. The scumming start temperature is preferably 30°C or more and more preferably 32°C or more, although it would vary depending on a printing environment. When the scumming start temperature is 30°C or more, printing without scumming is possible in a usual air-conditioned working environment, and when it is 32°C or more, strict temperature control is unnecessary, thereby making printing easier. In addition, there is a method of evaluating persistence of ink repellency, wherein continuous printing is carried out at the scumming start temperature so as to evaluate plate wear until scumming starts to become aggravated. Plate wear is preferably at a level of 10,000 sheets or more and more preferably 50,000 sheets or more. There is a correlation between plate wear and the plate surface elastic modulus. The level of plate wear increases if the plate surface elastic modulus is lower than 10 MPa.

### EXAMPLES

The invention will be further described below in detail with reference to examples. Preparation of materials and evaluation of the Examples and Comparative Examples were conducted by the following methods.

### (1) Ink preparation

An ink used in the Examples of the invention was prepared in the following method. This preparation method is descried in the Examples of Japanese Patent Application Laid-Open Publication No. HEI3-39373.

A solution was prepared by weighing 151 g of stearic acid chloride and 122 g of pentaerythritol diacrylate in a separable flask and adding 273 g of toluene. Further, 1 part by mass of p-toluenesulfonic acid and 0.5 parts by mass of hydroquinone were added to 100 parts by mass of the solution, followed by reaction at 140°C for 5 hours in the flow of nitrogen gas. Thus, acrylic ester was generated. Next, 20 parts by mass of the acrylic ester, 60 parts by mass of rosin-modified epoxy acrylate ("BANBEAM" 22C1, Harima Chemicals Group Inc.), 10 parts by mass of trimethylolpropane triacrylate ("Aronix" M309, Toagosei Co., Ltd.), and 10 parts by mass of alkyd resin ("Haridip" 116 AM, Harima Chemicals Group Inc.) were prepared and mixed by stirring in an oil bath at 100°C until uniformly dissolved. Thus, varnish was obtained. Next, a photopolymerization initiator ("Irgacure®;" the same applies hereafter) was added to the varnish. An ink was prepared by adding 6 parts by mass of 500/"Irgacure" 907 = 1/1 (Ciba-Geigy), 22 parts by mass of a pigment (Mitsubishi Carbon MA-7, Mitsubishi Chemical Corporation), and 0.1 parts by mass of a polymerization inhibitor (hydroquinone monomethyl ether), followed by sufficient kneading using a three roll mill. Note that the alkyd resin and the acrylic resin are commercially available in the solution form, and therefore, they were used after a solvent was removed under conditions of 760 mmHg (1 atmospheric pressure) at 1100°C for 8 hours.

In order to change the photosensitive component content in the ink, "DAISO ISO DAP®" (Daiso Co., Ltd.), which is a non-photocurable polymer, was added, if necessary, followed by sufficient kneading using a three roll mill. Thus, a UV ink was prepared. The mass of the composition obtained by removing "DAISO ISO DAP", the pigment, and the polymerization inhibitor from the UV ink was designated as the mass of the photosensitive component mass. The proportion of the mass of the photosensitive component contained in the total amount of the obtained UV ink was designated as the photosensitive component content.

### (2) Determination of the boiling point of the ink repellent liquid

In the present invention, a condition in which the boiling point of an ink repellent liquid is 150°C or more is defined as a condition in which a decrease in mass after static placement for 1 hour in an environment at 150°C, 1 atmospheric pressure is less than 0.5% by mass. In order to confirm the boiling point of the liquid used in Examples, 2 g of the liquid was weighed in an aluminium cup having a diameter of 50 mm and allowed to stand still in an oven at 150°C for 1 hour, and then a decrease in mass was determined. Based on the proportion of the decrease in mass, the liquid was confirmed to have a boiling point of 150°C or more.

### (3) Production of waterless lithographic printing plate

The waterless lithographic printing plate precursor used in the Examples was exposed to light using a CTP plate recorder "PlateRite" 8800E (Dainippon Screen Mfg., Co., Ltd.) at an irradiation energy of 130 mJ/cm² (number of drum rotations: 232 rpm). As an exposure image, a belt-like solid image of 20 mm in length and 650 mm in width was created at the center of a waterless lithographic printing plate precursor of 550 mm in length and 650 mm in width. The exposed plate precursor was passed through an automatic processor TWL-1160F (Toray Industries, Inc.) at a rate of 80 cm/minute using CP-Y (Toray Industries, Inc.) as a pre-treatment liquid and tap water as a developer. Thus, a waterless lithographic printing plate was produced.

### (4) UV printing

A printing tester was prepared by connecting a UV irradiator with a built-in speed-variable conveyor to a delivery unit of a sheetfed press "OLIVER 266 EPZ" (Sakurai Graphic Systems Corporation). The waterless lithographic printing plate produced in (3) above was attached to the printing tester so as to conduct a printing test using the UV ink prepared in (1) above or a commercially available ink. The ink was supplied to a printing plate via an ink roller, and the printing plate was brought into contact with a blanket, thereby transferring the ink from the printing plate to the blanket. Subsequently, the ink on the blanket was transferred to thin coated paper serving as a printing substrate by offset printing. The amount of the UV ink supplied was adjusted so as to set the reflection density of a solid printing area to 1.8 (ink), and the paper on which the UV ink was transferred was irradiate with ultraviolet light, thereby obtaining a printed material. A metal halide lamp with an output of 120 W/cm² was used for the test, and the UV light irradiation time was changed by setting the conveyor speed at different levels in an irradiation region with a focal length of 150 mm and a lamp house width in the flow direction of 100 mm.

### (5) Determination of plate surface elastic modulus

The plate surface elastic modulus was determined using an ultramicro hardness tester "Nano Indenter XP" (MTS Systems Corporation). A load-indentation depth diagram was created by pushing a conical diamond indenter (edge curvature radius = 50 µm) into the surface of the printing plate in the atmosphere at 25°C. Complex elastic modulus E* in consideration of contribution of elastic deformation of the indenter was calculated based on the obtained load-indentation depth diagram by the following formula (1).

P=4/3·E*·R^{1/2}·h^{3/2} ····· Formula (1)

Here, R represents a radius of the indenter (50 µm), P represents a load, and h represents a displacement.

Then, the elastic modulus E of a sample was obtained by the following formula (2).

1/E*=(1-v²)/E+(1-vᵢ²)/Eᵢ ····· Formula(2)

Here, v and E represent a Poisson's ratio (0.5) and an elastic modulus of a sample, respectively, and vᵢ and Eᵢ represent a Poisson's ratio (0.07) and an elastic modulus (1141 GPa) of an indenter, respectively.

In the Examples of the invention, the elastic modulus when a load of 1400 N/m² was applied was calculated by formulae (1) and (2) so as to calculate the plate surface elastic modulus.

### (6) Confirmation of UV ink curing time

During printing in (4) above, cellophane tape (No. 29, Nitto Denko Corporation) was applied to solid printing areas. It was judged that curing was completed when no transfer to cellophane tape was observed after removal of the tape, and the shortest ink curing time was confirmed.

### (7) Determination of scumming start temperature

During printing in (4) above, the ink roller temperature was controlled using a chiller so as to change the plate surface temperature of the waterless lithographic printing plate. The plate surface temperature was measured using a non-contact thermometer and scumming in non-imaging areas was checked at every measurement temperature.

### (8) Determination of plate wear

After measurement of scumming start temperature in (7) above, continuous printing was conducted while the temperature was maintained. The degree of scumming on the printed material was confirmed for every 5000 sheets, and plate wear was defined as the number of sheets with visually recognizable deterioration.

### (EXAMPLE 1)

A waterless lithographic printing plate precursor was produced by the following method.

The following heat insulating layer composition solution was applied onto a degreased aluminum substrate of 0.24 mm in thickness (Mitsubishi Aluminum Co., Ltd.), and was dried at 200°C for 90 seconds, thereby forming a heat insulating layer having a film thickness of 6.0 µm. The heat insulating layer composition solution was obtained by mixing the following components during stirring at room temperature.

### <Heat insulating layer composition solution>

(a) active hydrogen-containing polymer: epoxy resin: "Epicote®" 1010 (Japan Epoxy Resins Co., Ltd.): 35 parts by mass
(b) active hydrogen-containing polymer: polyurethane: "Sanprene®" LQ-T1331D (Sanyo Chemical Industries Ltd.; solid component concentration: 20% by mass): 375 parts by mass
(c) alumichelate: "Alumichelate" ALCH-TR (Kawaken Fine Chemicals Co., Ltd.): 10 parts by mass
(d) levelling agent: "Disparlon®" LC951 (Kusumoto Chemical Co., Ltd.; solid component concentration: 10% by mass): 1 part by mass
(e) titanium oxide: N,N-dimethylformamide dispersion (titanium oxide: 50% by mass): 60 parts by mass of "Tipaque®" CR-50 (Ishihara Sangyo Kaisya, Ltd.)
(f) N,N-dimethylformamide: 730 parts by mass
(g) methyl ethyl ketone: 250 parts by mass

Then, the following heat sensitive layer composition solution was applied onto the heat insulating layer and dried at 140°C for 90 seconds, thereby forming a heat sensitive layer of 1.5 µm in film thickness. The heat sensitive layer composition solution was obtained by mixing the following components during stirring at room temperature.

### <Heat sensitive layer composition solution-1>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 15.0 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 25 parts by mass
(e) tetrahydrofuran: 1044 parts by mass

Then, the following ink repellent layer composition solution-1 that had been prepared immediately before use was applied onto the heat sensitive layer, and the coating film was heated at 140°C for 80 seconds so as to form an ink repellent layer having an average film thickness of 2.5 µm. Thus, a waterless lithographic printing plate precursor was obtained. The ink repellent layer composition solution-1 was obtained by mixing the following components during stirring at room temperature.

### <Ink repellent layer composition solution-1>

(a) α,ω-divinyl polydimethylsiloxane: TF22 (weight average molecular weight: 100,000; Dow Corning Toray Co., Ltd.): 80.0 parts by mass
(b) silicone oil: KF-96-50cs (polydimethylsiloxane sealed with methyl groups at both ends; weight average molecular weight: 3780; surface tension: 20.8 mN/m; boiling point: > 150°C; Shin-Etsu Chemical Co., Ltd.): 10.0 parts by mass (c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Toray Dow Corning Silicone Co.): 6.17 parts by mass
(f) isoparaffin type hydrocarbon solvent "Isopar®" E (by Esso Chemical K.K.): 900 parts by mass

The obtained waterless lithographic printing plate was subjected to a printing test by the above method using a UV ink having a photosensitive component content of 10% by mass. The ink curing time was 2 seconds, and the scumming start temperature was 33°C, which were favorable results.

### (EXAMPLE 2)

A printing test was conducted as described in Example 1 except that a UV ink having a photosensitive component content of 30% by mass was used. The ink curing time was 1 second, and the scumming start temperature was 32°C, which were very favorable results.

### (EXAMPLE 3)

A printing test was conducted as described in Example 1 except that a UV ink having a photosensitive component content of 50% by mass was used. The ink curing time was 0.5 seconds, and the scumming start temperature was 31°C, which were favorable results.

### (EXAMPLE 4)

A waterless lithographic printing plate precursor was obtained as described in Example 1 except that the ink repellent layer composition solution-1 was replaced by the following ink repellent layer composition solution-2.

### <Ink repellent layer composition solution-2>

(a) α,ω-divinyl polydimethylsiloxane: TF22 (weight average molecular weight: 100,000; Dow Corning Toray Co., Ltd.): 75.0 parts by mass
(b) silicone oil: KF-96-50cs (weight average molecular weight: 3,780; surface tension: 20.8 mN/m; boiling point: > 150°C; Shin-Etsu Chemical Co., Ltd.): 15.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 50% by mass. The ink curing time was 0.5 seconds, and the scumming start temperature was 33°C, which were very favorable results.

### (EXAMPLE 5)

A waterless lithographic printing plate precursor was obtained as described in Example 1 except that the ink repellent layer composition solution-1 was replaced by the following ink repellent layer composition solution-3.

### <Ink repellent layer composition solution-3 >

(a) α,ω-divinyl polydimethylsiloxane: "TF" 22 (weight average molecular weight: 100,000; Dow Corning Toray Co., Ltd.): 65.0 parts by mass
(b) silicone oil: KF-96-50cs (weight average molecular weight: 3,780; surface tension: 20.8 mN/m; boiling point: > 150°C; Shin-Etsu Chemical Co., Ltd.): 25.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 50% by mass. The ink curing time was 0.5 seconds, and the scumming start temperature was 35°C, which were very favorable results.

### (EXAMPLE 6)

A waterless lithographic printing plate precursor was obtained as described in Example 1 except that the ink repellent layer composition solution-1 was replaced by the following ink repellent layer composition solution-4.

### <Ink repellent layer composition solution-4>

(a) α,ω-divinyl polydimethylsiloxane: "TF" 22 (weight average molecular weight: 100,000; Dow Corning Toray Co., Ltd.): 60.0 parts by mass
(b) silicone oil: KF-96-50cs (weight average molecular weight: 3,780; surface tension: 20.8 mN/m; boiling point: > 150°C; Shin-Etsu Chemical Co., Ltd.): 30.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 50% by mass. The ink curing time was 0.5 seconds, and the scumming start temperature was 36°C, which were very favorable results.

### (EXAMPLE 7)

A waterless lithographic printing plate precursor was obtained as described in Example 1 except that the ink repellent layer composition solution-1 was replaced by the following ink repellent layer composition solution-5.

### <Ink repellent layer composition solution-5>

(a) α,ω-divinyl polydimethylsiloxane: TF22 (weight average molecular weight: 100,000; Dow Corning Toray Co., Ltd.): 70.0 parts by mass
(b) silicone oil: KF-96-10cs (weight average molecular weight: 1,250; surface tension: 20.1 mN/m; boiling point: > 150°C; Shin-Etsu Chemical Co., Ltd.): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 30% by mass. The ink curing time was 1 second, and the scumming start temperature was 34°C, which were very favorable results.

### (EXAMPLE 8)

A waterless lithographic printing plate precursor was obtained as described in Example 1 except that the ink repellent layer composition solution-1 was replaced by the following ink repellent layer composition solution-6.

### <Ink repellent layer composition solution-6>

(a) α,ω-divinyl polydimethylsiloxane: TF22 (weight average molecular weight: 100,000; Dow Corning Toray Co., Ltd.): 70.0 parts by mass
(b) silicone oil: KF-96-60000cs (weight average molecular weight: 116,500; surface tension: 21.3 mN/m; boiling point: > 150°C; Shin-Etsu Chemical Co., Ltd.): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 30% by mass. The ink curing time was 1 second, and the scumming start temperature was 32°C, which were very favorable results.

### (EXAMPLE 9)

A waterless lithographic printing plate precursor was obtained as described in Example 1 except that the ink repellent layer composition solution-1 was replaced by the following ink repellent layer composition solution-7.

### <Ink repellent layer composition solution-7>

(a) α,ω-divinyl polydimethylsiloxane: TF22 (weight average molecular weight: 100,000; Dow Corning Toray Co., Ltd.): 70.0 parts by mass
(b) fluoro-modified silicone oil: FL-100-100 cs (weight average molecular weight: 5,970; boiling point: > 150°C; Shin-Etsu Chemical Co., Ltd.): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 30% by mass. The ink curing time was 1 second, and the scumming start temperature was 34°C, which were very favorable results.

### (EXAMPLE 10)

A waterless lithographic printing plate precursor was obtained as described in Example 1 except that the ink repellent layer composition solution-1 was replaced by the following ink repellent layer composition solution-8.

### <Ink repellent layer composition solution-8>

(a) α,ω-divinyl polydimethylsiloxane: TF22 (weight average molecular weight: 100,000; Dow Corning Toray Co., Ltd.): 70.0 parts by mass
(b) hydrocarbon solvent: "Solvesso®" 100 (surface tension: 29 mN/m; boiling point: > 150°C; Exxon Mobil Corporation): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 30% by mass. The ink curing time was 1 second, and the scumming start temperature was 32°C, which were very favorable results.

### (EXAMPLE 11)

A waterless lithographic printing plate precursor was obtained as described in Example 1 except that the ink repellent layer composition solution-1 was replaced by the following ink repellent layer composition solution-9.

### <Ink repellent layer composition solution-9>

(a) α,ω-divinyl polydimethylsiloxane: TF22 (weight average molecular weight: 100,000; Dow Corning Toray Co., Ltd.): 70.0 parts by mass
(b) hydrocarbon solvent: "Solvesso" 200 (surface tension: 36 mN/m; boiling point: > 150°C; Exxon Mobil Corporation): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The obtained waterless lithographic printing plate was subjected to a printing test by the above method using a UV ink having a photosensitive component content of 30% by mass. The ink curing time was 1 second, and the scumming start temperature was 31°C, which were favorable results.

### (REFERENCE EXAMPLE¹ 12)

¹ The Reference Examples are outside the scope of the invention

A waterless lithographic printing plate precursor was obtained as described in Example 1 except that the heat sensitive layer composition solution-1 was replaced by the heat sensitive layer composition solution-2, and the ink repellent layer composition solution-1 was replaced by the following ink repellent layer composition solution-10.

### <Heat sensitive layer composition solution-2>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 20.5 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 30.1 parts by mass
(e) tetrahydrofuran: 807 parts by mass

### <Ink repellent layer composition solution-10>

(a) α,ω-divinyl polydimethylsiloxane: TF22 (weight average molecular weight: 100,000; Dow Corning Toray Co., Ltd.): 85.0 parts by mass
(b) hydrocarbon solvent: "Solvesso" 200 (surface tension: 36 mN/m; boiling point: > 150°C; Exxon Mobil Corporation): 5.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 12.0 MPa. A printing test was conducted by the above method using a UV ink "UV171CT TW"-M (T&K TOKA Corporation). The scumming start temperature was 30°C, and plate wear was at a level of 10,000 sheets, which were favorable results.

### (REFERENCE EXAMPLE 13)

A waterless lithographic printing plate precursor was obtained as described in Example 12 except that the ink repellent layer composition solution-10 was replaced by the following ink repellent layer composition solution-11.

### <Ink repellent layer (silicone rubber layer) composition solution-11>

(a) α,ω-divinyl polydimethylsiloxane: TF22 (weight average molecular weight: 100,000; Dow Corning Toray Co., Ltd.): 85.0 parts by mass
(b) hydrocarbon solvent: "Solvesso" 100 (surface tension: 29 mN/m; boiling point: > 150°C; Exxon Mobil Corporation): 5.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 12.0 MPa. A printing test was conducted by the above method using a UV ink "UV171CT TW"-M (T&K TOKA Corporation). The scumming start temperature was 30°C, and plate wear was at a level of 10,000 sheets, which were favorable results.

### (REFERENCE EXAMPLE 14)

A waterless lithographic printing plate precursor was obtained as described in Example 12 except that the ink repellent layer composition solution-10 was replaced by the following ink repellent layer composition solution-12.

### <Ink repellent layer composition solution-12>

(a) α,ω-divinyl polydimethylsiloxane: TF22 (weight average molecular weight: 100,000; Dow Corning Toray Co., Ltd.): 85.0 parts by mass
(b) silicone oil: KF-96-50cs (weight average molecular weight: 3,780; surface tension: 20.8 mN/m; boiling point: > 150°C; Shin-Etsu Chemical Co., Ltd.): 5.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 12.0 MPa. A printing test was conducted by the above method using a UV ink "UV171CT TW"-M (T&K TOKA Corporation). The scumming start temperature was 32°C, and plate wear was at a level of 10,000 sheets, which were favorable results.

### (REFERENCE EXAMPLE 15)

A waterless lithographic printing plate precursor was obtained as described in Example 12 except that the ink repellent layer composition solution-10 was replaced by the following ink repellent layer composition solution-13.

### <Ink repellent layer composition solution-13 >

(a) α,ω-divinyl polydimethylsiloxane: TF22 (weight average molecular weight: 100,000; Dow Corning Toray Co., Ltd.): 50.0 parts by mass
(b) silicone oil: KF-96-50cs (weight average molecular weight: 3,780; surface tension: 20.8 mN/m; boiling point: > 150°C; Shin-Etsu Chemical Co., Ltd.): 40.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 4.0 MPa. A printing test was conducted by the above method using a UV ink "UV171CT TW"-M (T&K TOKA Corporation). The scumming start temperature was 37°C, and plate wear was at a level of 10,000 sheets, which were favorable results.

### (EXAMPLE 16)

A waterless lithographic printing plate precursor was obtained as described in Example 12 except that the ink repellent layer composition solution-10 was replaced by the ink repellent layer composition solution-1.

The plate surface elastic modulus of the obtained waterless lithographic printing plate was measured, and it was 10.0 MPa. A printing test was conducted by the above method using a UV ink "UV171CT TW"-M (T&K TOKA Corporation). The scumming initiation temperature was 34°C, and plate wear was at a level of 90,000 sheets, which were very favorable results.

### (EXAMPLE 17)

A waterless lithographic printing plate precursor was obtained as described in Example 12 except that the ink repellent layer composition solution-10 was replaced by the following ink repellent layer composition solution-14.

### <Ink repellent layer composition solution-14>

(a) α,ω-divinyl polydimethylsiloxane: TF22 (weight average molecular weight: 100,000; Dow Corning Toray Co., Ltd.): 70.0 parts by mass
(b) silicone oil: KF-96-50cs (weight average molecular weight: 3,780; surface tension: 20.8 mN/m; boiling point: > 150°C; Shin-Etsu Chemical Co., Ltd.): 20.0 parts by mass
(c) methyhydrogensiloxane HMS305 (GELEST Inc.): 2.95 parts by mass
(d) vinyltris(methyl ethyl ketoximino)silane: 0.88 parts by mass
(e) platinum catalyst "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 9.0 MPa. A printing test was conducted by the above method using a UV ink "UV171CT TW"-M (T&K TOKA Corporation). The scumming initiation temperature was 35°C, and plate wear was at a level of 100,000 sheets, which were very favorable results.

### (EXAMPLE 18)

A waterless lithographic printing plate precursor was obtained as described in Example 17 except that the heat sensitive layer composition solution-2 was replaced by the following heat sensitive layer composition solution-3.

### <Heat sensitive layer composition solution-3>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 16.4 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 40 parts by mass
(e) tetrahydrofuran: 801 parts by mass

The plate surface elastic modulus of the obtained waterless lithographic printing plate was measured, and it was 9.0 MPa. A printing test was conducted by the above method using a UV ink "UV171CT TW"-M (T&K TOKA Corporation). The scumming initiation temperature was 35°C, and plate wear was at a level of 100,000 sheets, which were very favorable results.

### (EXAMPLE 19)

A waterless lithographic printing plate precursor was obtained as described in Example 17 except that the heat sensitive layer composition solution-2 was replaced by the following heat sensitive layer composition solution-4.

### <Heat sensitive layer composition solution-4>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 14.9 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 43.7 parts by mass
(e) tetrahydrofuran: 799 parts by mass

The plate surface elastic modulus of the obtained waterless lithographic printing plate was measured, and it was 10.0 MPa. A printing test was conducted by the above method using a UV ink "UV171CT TW"-M (T&K TOKA Corporation). The scumming initiation temperature was 35°C, and plate wear was at a level of 90,000 sheets, which were very favorable results.

### (EXAMPLE 20)

A waterless lithographic printing plate precursor was obtained as described in Example 12 except that the ink repellent layer composition solution-10 was replaced by the ink repellent layer composition solution-4.

The plate surface elastic modulus of the obtained waterless lithographic printing plate was measured, and it was 7.0 MPa. A printing test was conducted by the above method using a UV ink "UV171CT TW"-M (T&K TOKA Corporation). The scumming initiation temperature was 36°C, and plate wear was at a level of 80,000 sheets, which were very favorable results.

### (EXAMPLE 21)

A waterless lithographic printing plate precursor was obtained as described in Example 20 except that the heat sensitive layer composition solution-2 was replaced by the following heat sensitive layer composition solution-5.

### <Heat sensitive layer composition solution-5>

(a) infrared-absorbing dye: "PROJET" 825LDI (Avecia): 8.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 41.1 parts by mass
(c) phenol formaldehyde novolac resin: "Sumilite Resin®" PR53195 (by Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 6.7 parts by mass
(e) tetrahydrofuran: 818 parts by mass

The plate surface elastic modulus of the obtained waterless lithographic printing plate was measured, and it was 5.0 MPa. A printing test was conducted by the above method using a UV ink "UV171CT TW"-M (T&K TOKA Corporation). The scumming start temperature was 36°C, and plate wear was at a level of 40,000 sheets, which were favorable results.

### (EXAMPLE 22)

A waterless lithographic printing plate precursor was obtained as described in Example 16 except that the heat sensitive layer composition solution-2 was replaced by the following heat sensitive layer composition solution-6.

### <Heat sensitive layer composition solution-6>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 13.7 parts by mass
(c) phenol formaldehyde novolac resin: "Sumilite Resin®" PR53195 (by Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 46.7 parts by mass
(e) tetrahydrofuran: 797 parts by mass

The plate surface elastic modulus of the obtained waterless lithographic printing plate was measured, and it was 11.0 MPa. A printing test was conducted by the above method using a UV ink "UV171CT TW"-M (T&K TOKA Corporation). The scumming start temperature was 34°C, and plate wear was at a level of 60,000 sheets, which were favorable results.

### (EXAMPLE 23)

A waterless lithographic printing plate precursor was obtained as described in Example 20 except that the heat sensitive layer composition solution-2 was replaced by the following heat sensitive layer composition solution-7.

### <Heat sensitive layer composition solution-7>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 54.8 parts by mass
(c) phenol formaldehyde novolac resin: "Sumilite Resin®" PR53195 (Sumitomo Bakelite Co., Ltd.): 40 parts by mass
(d) polyurethane: "Nippolan®" 5196 (Nippon Polyurethane Industry Co., Ltd.: concentration: 30% by mass; containing the following solvents: methyl ethyl ketone: 35% by mass; cyclohexanone: 35% by mass): 13.3 parts by mass
(e) tetrahydrofuran: 809 parts by mass

The plate surface elastic modulus of the obtained waterless lithographic printing plate was measured, and it was 4.0 MPa. A printing test was conducted by the above method using a UV ink "UV171CT TW"-M (T&K TOKA Corporation). The scumming start temperature was 36°C, and plate wear was at a level of 10,000 sheets, which were favorable results.

### (EXAMPLE 24)

A waterless lithographic printing plate precursor was obtained as described in Example 16 except that the heat sensitive layer composition solution-2 was replaced by the following heat sensitive layer composition solution-8.

### <Heat sensitive layer composition solution-8>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 12.6 parts by mass
(c) phenol formaldehyde novolac resin: "Sumilite Resin®" PR53195 (by Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 49.3 parts by mass
(e) tetrahydrofuran: 795 parts by mass

The plate surface elastic modulus of the obtained waterless lithographic printing plate was measured, and it was 12.0 MPa. A printing test was conducted by the above method using a UV ink "UV171CT TW"-M (T&K TOKA Corporation). The scumming start temperature was 34°C, and plate wear was at a level of 10,000 sheets, which were favorable results.

### (EXAMPLE 25)

A waterless lithographic printing plate precursor was obtained as described in Example 24 except that the ink repellent layer composition solution-1 was replaced by the ink repellent layer composition solution-14.

The plate surface elastic modulus of the obtained waterless lithographic printing plate was measured, and it was 11.5 MPa. A printing test was conducted by the above method using a UV ink "UV171CT TW"-M (T&K TOKA Corporation). The scumming start temperature was 35°C, and plate wear was at a level of 30,000 sheets, which were favorable results.

### (EXAMPLE 26)

A printing test was conducted by the above method using a UV ink "UV171CT TW"-M (T&K TOKA Corporation) to which dodecylacrylate had been added to result in 10% by mass with respect to the total amount. The scumming start temperature was 38°C, and plate wear was at a level of 100,000 sheets, which were very favorable results.

### (EXAMPLE 27)

The waterless lithographic printing plate obtained in Example 17 was subjected to a printing test conducted by the above method using an oil-based "Alpo GT SOYA"-M (T&K TOKA Corporation) as an ink containing no photosensitive component except that blast drying other than ultraviolet irradiation was performed. The scumming start temperature was 38°C, and plate wear was at a level of 100,000 sheets, which were very favorable results.

### (COMPARATIVE EXAMPLE 1)

A waterless lithographic printing plate precursor was obtained as described in Example 1 except that the ink repellent layer composition solution-1 was replaced by the following ink repellent layer composition solution-15.

### <Ink repellent layer composition solution-15>

(a) α,ω-divinyl polydimethylsiloxane: TF22 (weight average molecular weight: 100,000; Dow Corning Toray Co., Ltd.): 90.0 parts by mass
(b) methyhydrogensiloxane HMS305 (GELEST Inc.): 2.95 parts by mass
(c) vinyltris(methyl ethyl ketooxyimino)silane 0.88 parts by mass
(d) platinum catalyst: "SRX212" (Dow Corning Toray Co., Ltd.): 6.17 parts by mass
(e) "Isopar" E (Esso Chemical) 900 parts by mass

The obtained waterless lithographic printing plate was subjected to a printing test conducted by the above method using an oil-based "Alpo GT SOYA"-M (T&K TOKA Corporation) as an ink containing no photosensitive component except that blast drying other than ultraviolet irradiation was performed. The ink curing time was 1 hour or longer, and the scumming start temperature was 32°C, meaning that a sufficient level of the ink curing rate was not achieved.

### (COMPARATIVE EXAMPLE 2)

A waterless lithographic printing plate precursor was obtained as described in Example 1 except that the ink repellent layer composition solution-1 was replaced by the ink repellent layer composition solution-12.

The obtained waterless lithographic printing plate was subjected to a printing test conducted by the above method using an oil-based "Alpo GT SOYA"-M (T&K TOKA Corporation) as an ink containing no photosensitive component except that blast drying other than ultraviolet irradiation was performed. The ink curing time was 1 hour or longer, and the scumming start temperature was 34°C, meaning that a sufficient level of the ink curing rate was not achieved.

### (COMPARATIVE EXAMPLE 3)

A waterless lithographic printing plate precursor was obtained as described in Example 24 except that the ink repellent layer composition solution-1 was replaced by the ink repellent layer composition solution-15.

The plate surface elastic modulus of the obtained waterless lithographic printing plate was measured, and it was 12.5 MPa. A printing test was conducted by the above method using a UV ink "UV171CT TW"-M (T&K TOKA Corporation). The scumming start temperature was 28°C, and plate wear was at a level of 5,000 sheets, meaning that ink repellency was not maintained.

### (COMPARATIVE EXAMPLE 4)

A waterless lithographic printing plate precursor was obtained as described in Example 24 except that the ink repellent layer composition solution-1 was replaced by the following ink repellent layer composition solution-16.

### <Ink repellent layer composition solution-16>

(a) α,ω-divinyl polydimethylsiloxane: TF22 (weight average molecular weight: 100,000; Dow Corning Toray Co., Ltd.): 85.0 parts by mass
(b) octane (surface tension: 21.1 mN/m; boiling point: 125°C; Wako Pure Chemical Industries, Ltd.) 5.0 parts by mass
(c) methyhydrogensiloxane HMS305 (GELEST Inc.): 2.95 parts by mass
(d) vinyltris(methyl ethyl ketoximino)silane: 0.88 parts by mass
(d) platinum catalyst: "SRX212" (Dow Corning Toray Co., Ltd.): 6.17 parts by mass
(f) "Isopar" E (Esso Chemical): 900 parts by mass

The plate surface elastic modulus of the obtained waterless lithographic printing plate was measured, and it was 12.5 MPa. A printing test was conducted by the above method using a UV ink "UV171CT TW"-M (T&K TOKA Corporation). The scumming start temperature was 28°C, and plate wear was at a level of 5,000 sheets, meaning that ink repellency was not maintained.

### (COMPARATIVE EXAMPLE 5)

The waterless lithographic printing plate obtained in Comparative Example 4 was subjected to a printing test conducted by the above method using an oil-based "Alpo GT SOYA"-M (T&K TOKA Corporation) as an ink containing no photosensitive component except that blast drying other than ultraviolet irradiation was performed. The scumming start temperature was 30°C, and plate wear was at a level of 5,000 sheets, meaning that ink repellency was not maintained.

Tables 1 and 2 list the composition and printing performance of ink, ink repellent layer, and heat sensitive layer.

### [Table 1]

**[Table 1]**

| | Ink Repellent Layer | | | | | Ink | | Printing Quality | |
|---|---|---|---|---|---|---|---|---|---|
| | Ink Repellent Composition Liquid No. | Liquid in ink repellent layer | | | | | | | |
| | | Name | Surface Tension (mN/m) | Boiling Point (°C) | Amount Added (% by mass) | Curing Method | Photosensitive Component Content (% by mass) | Ink Curing Time | Scumming Start Temperature (°C) |
| Example 1 | 1 | KF-96-50cs | 20.8 | >150 | 10 | UV irradiation | 10 | 2 seconds | 33 |
| Example 2 | 1 | KF-96-50cs | 20.8 | >150 | 10 | UV irradiation | 30 | 1 second | 32 |
| Example 3 | 1 | KF-96-50cs | 20.8 | >150 | 10 | UV irradiation | 50 | 0.5 seconds | 31 |
| Example 4 | 2 | KF-96-50cs | 20.8 | >150 | 15 | UV irradiation | 50 | 0.5 seconds | 33 |
| Example 5 | 3 | KF-96-50cs | 20.8 | >150 | 25 | UV irradiation | 50 | 0.5 seconds | 35 |
| Example 6 | 4 | KF-96-50cs | 20.8 | >150 | 30 | UV irradiation | 50 | 0.5 seconds | 36 |
| Example 7 | 5 | KF-96-10cs | 20.1 | >150 | 20 | UV irradiation | 30 | 1 second | 34 |
| Example 8 | 6 | KF-96H-60,000cs | 21.3 | >150 | 20 | UV irradiation | 30 | 1 second | 32 |
| Example 9 | 7 | FL-100-100cs | - | >150 | 20 | UV irradiation | 30 | 1 second | 34 |
| Example 10 | 8 | Solvesso 100 | 29 | >150 | 20 | UV irradiation | 30 | 1 second | 32 |
| Example 11 | 9 | Solvesso 200 | 36 | >150 | 20 | UV irradiation | 30 | 1 second | 31 |
| Comparative Example 1 | 15 | None | | | | Air drying | 0 | 1 hour or more | 32 |
| Comparative Example 2 | 12 | KF-96-50cs | 20.8 | >150 | 5 | Air drying | 0 | 1 hour or more | 34 |

**[Table 2]**

| | Heat Sensitive Layer Composition | | | | | Ink Repellent Layer | | | | | Plate Surface Elastic Modulus (MPa) | Ink Type | Printing Performance | |
|---|---|---|---|---|---|---|---|---|---|---|---|---|---|---|
| | Heat Sensitive Layer Composition Solution No. | Novolak resin content (part by mass) | Amount of Organic Complex Compound Added (including solvent) (part by mass) | Solid Component Concentration of Organic Complex Compound (part by mass) | Mass Ratio of Novolak Resin / Organic Complex Compound | Ink Repellent Composition Solution No. | Liquid in Ink Repellent Layer | | | | | | Scumming Start Temperature (°C) | Plate Wear (No. of Sheets ) |
| | | | | | | | Name | Boiling Point (°C) | Surface Tension (mN/m ) | Amount Added (wt%) | | | | |
| Reference Example 12 | 2 | 60 | 20,5 | 15,0 | 4,0 | 10 | Solves so 200 | >150 | 36 | 5 | 12,0 | UV Ink | 30 | 10000 |
| Reference Example 13 | 2 | 60 | 20,5 | 15,0 | 4,0 | 11 | Solves so 100 | >150 | 29 | 5 | 12,0 | UV Ink | 30 | 10000 |
| Reference Example 14 | 2 | 60 | 20,5 | 15,0 | 4,0 | 12 | KF-96-50cs | >150 | 20,8 | 5 | 12,0 | UV Ink | 32 | 10000 |
| Reference Example 15 | 2 | 60 | 20,5 | 15,0 | 4,0 | 13 | KF-96-50cs | >150 | 20,8 | 40 | 4,0 | UV Ink | 37 | 10000 |
| Example 16 | 2 | 60 | 20,5 | 15,0 | 4,0 | 1 | KF-96-50cs | >150 | 20,8 | 10 | 10,0 | UV Ink | 34 | 90000 |
| Example 17 | 2 | 60 | 20,5 | 15,0 | 4,0 | 14 | KF-96-50cs | >150 | 20,8 | 20 | 9,0 | UV Ink | 35 | 100000 |
| Example 18 | 3 | 60 | 16,4 | 12,0 | 5,0 | 14 | KF-96-50cs | >150 | 20,8 | 20 | 9,0 | UV Ink | 35 | 100000 |
| Example 19 | 4 | 60 | 14,9 | 10,9 | 5,5 | 14 | KF-96-50cs | >150 | 20,8 | 20 | 10,0 | UV Ink | 35 | 90000 |
| Example 20 | 2 | 60 | 20,5 | 15,0 | 4,0 | 4 | KF-96-50cs | >150 | 20,8 | 30 | 7,0 | UV Ink | 36 | 80000 |

### [Table 3-1]

**[Table 3-1]**

| | Heat Sensitive Layer Composition | | | | | Ink Repellent Layer | | | | |
|---|---|---|---|---|---|---|---|---|---|---|
| | Heat Sensitive Layer Composition Solution No. | Novolak resin content (part by mass) | Amount of Organic Complex Compound Added (including solvent) (part by mass) | Solid Component Concentration of Organic Complex Compound (part by mass) | Mass Ratio of Novolak Resin / Organic Complex Compound | Ink Repellent Composition Solution No. | Liquid in Ink Repellent Layer | | | |
| | | | | | | | Name | Boiling Point (°C) | Surface Tension (mN/m) | Amount Added (wt%) |
| Example 21 | 5 | 60 | 41.1 | 30.0 | 2.0 | 4 | KF-96-50cs | >150 | 20.8 | 30 |
| Example 22 | 6 | 60 | 13.7 | 10.0 | 6.0 | 1 | KF-96-50cs | >150 | 20.8 | 10 |
| Example 23 | 7 | 40 | 54.8 | 40.0 | 1.0 | 4 | KF-96-50cs | >150 | 20.8 | 30 |
| Example 24 | 8 | 60 | 12.6 | 9.2 | 6.5 | 1 | KF-96-50cs | >150 | 20.8 | 10 |
| Example 25 | 8 | 60 | 12.6 | 9.2 | 6.5 | 14 | KF-96-50cs | >150 | 20.8 | 20 |
| Example 26 | 2 | 60 | 20.5 | 15.0 | 4.0 | 14 | KF-96-50cs | >150 | 20.8 | 20 |
| Example 27 | 2 | 60 | 20.5 | 15.0 | 4.0 | 14 | KF-96-50cs | >150 | 20.8 | 20 |
| Comparative Example 3 | 8 | 60 | 12.6 | 9.2 | 6.5 | 15 | None | | | |
| Comparative Example 4 | 8 | 60 | 12.6 | 9.2 | 6.5 | 16 | Octane | 125 | 21.1 | 5 |
| Comparative Example 5 | 8 | 60 | 12.6 | 9.2 | 6.5 | 16 | Octane | 125 | 21.1 | 5 |

**[Table 3-2]**

| | Plate Surface Elastic Modulus (MPa) | Ink Type | Printing Performance | |
|---|---|---|---|---|
| | | | | |
| | | | Scumming Start Temperature (°C) | Plate Wear (No. of Sheets) |
| Example 21 | 5.0 | UV ink | 36 | 40000 |
| Example 22 | 11.0 | UV ink | 34 | 60000 |
| Example 23 | 4.0 | UV ink | 36 | 10000 |
| Example 24 | 12.0 | UV ink | 34 | 10000 |
| Example 25 | 11.5 | UV ink | 35 | 30000 |
| Example 26 | 9.0 | UV ink containing dodecyl acrylate | 38 | 100000 |
| Example 27 | 9.0 | Oil-based ink | 38 | 100000 |
| Comparative Example 3 | 12.5 | UV ink | 28 | 5000 |
| Comparative Example 4 | 12.5 | UV ink | 28 | 5000 |
| Comparative Example 5 | 12.5 | Oil-based ink | 30 | 5000 |

## Claims

1. A lithographic printing plate precursor comprising a substrate and at least a heat sensitive layer and an ink repellent layer, wherein the ink repellent layer which is a silicone rubber layer contains an ink repellent liquid, the ink repellent liquid having a boiling point of not less than 150°C at 101,3 kPa (1 atmospheric pressure), wherein the ink repellent layer contains the liquid in an amount of from 10% by mass to 30% by mass.

2. The lithographic printing plate precursor according to claim 1, wherein the liquid has a surface tension of from 15 mN/m to 30 mN/m at 25°C.

3. The lithographic printing plate precursor according to claim 1 or 2, wherein the heat sensitive layer contains a novolak resin.

4. The lithographic printing plate precursor according to claim 3, wherein the heat sensitive layer contains from 20% by mass to 95% by mass of the novolak resin.

5. The lithographic printing plate precursor according to claim 3 or 4, wherein the heat sensitive layer contains an organic complex compound.

6. The lithographic printing plate precursor according to claim 5, wherein the heat sensitive layer contains the novolak resin and the organic complex compound at a mass ratio of from 2 to 6.

7. The lithographic printing plate precursor according to any one of claims 1 to 7, which has a plate surface elastic modulus of from 4 MPa to 12 MPa when a load of 1400 N/m² is applied to the surface thereof.

8. A method of producing a lithographic printing plate, comprising the steps of:
exposing the lithographic printing plate precursor according to any one of claims 1 to 7 to light in accordance with an image; and
developing the exposed lithographic printing plate precursor to remove the ink repellent layer.

9. A method of producing a printed material, comprising the steps of:
allowing an ink to adhere to the surface of the lithographic printing plate obtained according to claim 8; and
transferring the ink directly or via a blanket to a printing substrate.

10. The method of producing a printed material according to claim 9, further comprising a step of irradiating the ink transferred to the printing substrate with an active energy ray.

11. The method of producing a printed material according to claim 10, comprising irradiating the printing substrate with ultraviolet light,
wherein the lithographic printing plate comprises the ink repellent layer on a substrate, the ink repellent liquid contained in the ink repellent layer has a surface tension of 30 mN/m or less, and the ink contains from 10% by mass to 50% by mass of a photosensitive component.

12. The method of producing a printed material according to claim 11, wherein the liquid is a silicone material.

13. The method of producing a printed material according to claim 11 or 12, wherein the ink repellent layer contains from 10% by mass to 25% by mass of the liquid.

14. The method of producing a printed material according to any one of claims 9 to 13, wherein the ink contains from 0.5% by mass to 15% by mass of an acrylate ester or methacrylate ester having a linear-chain alkyl group.

## Patentansprüche

1. Lithographischer Druckplattenvorläufer, umfassend ein Substrat und zumindest eine wärmeempfindliche Schicht und eine farbabweisende Schicht, wobei die farbabweisende Schicht, die eine Silikongummischicht ist, eine farbabweisende Flüssigkeit enthält, wobei die farbabweisende Flüssigkeit einen Siedepunkt von nicht weniger als 150 °C bei 101,3 kPa (1 Atmosphärendruck) aufweist, wobei die farbabweisende Schicht die Flüssigkeit in einer Menge von 10 Masse-% bis 30 Masse-% enthält.

2. Lithographischer Druckplattenvorläufer nach Anspruch 1, wobei die Flüssigkeit bei 25 °C eine Oberflächenspannung von 15 mN/m bis 30 mN/m aufweist.

3. Lithographischer Druckplattenvorläufer nach Anspruch 1 oder 2, wobei die wärmeempfindliche Schicht ein Novolakharz enthält.

4. Lithographischer Druckplattenvorläufer nach Anspruch 3, wobei die wärmeempfindliche Schicht 20 Masse-% bis 95 Masse-% des Novolakharzes enthält.

5. Lithographischer Druckplattenvorläufer nach Anspruch 3 oder 4, wobei die wärmeempfindliche Schicht eine organische Komplexverbindung enthält.

6. Lithographischer Druckplattenvorläufer nach Anspruch 5, wobei die wärmeempfindliche Schicht das Novolakharz und die organische Komplexverbindung in einem Massenverhältnis von 2 zu 6 enthält.

7. Lithographischer Druckplattenvorläufer nach einem der Ansprüche 1 bis 7, der einen Plattenoberflächen-Elastizitätsmodul von 4 MPa bis 12 MPa aufweist, wenn eine Last von 1400 N/m² auf dessen Oberfläche aufgebracht wird.

8. Verfahren zur Herstellung einer lithographischen Druckplatte, umfassend die Schritte:
Belichten des lithographischen Druckplattenvorläufers nach einem der Ansprüche 1 bis 7 mit Licht in Übereinstimmung mit einem Bild; und
Entwickeln des belichteten lithographischen Druckplattenvorläufers, um die farbabweisende Schicht zu entfernen.

9. Verfahren zur Herstellung eines bedruckten Materials, umfassend die Schritte:
Anhaftenlassen einer Druckfarbe auf der Oberfläche der nach Anspruch 8 erhaltenen lithografischen Druckplatte; und
Übertragen der Druckfarbe direkt oder über ein Tuch auf ein Drucksubstrat.

10. Verfahren zur Herstellung eines bedruckten Materials nach Anspruch 9, des Weiteren umfassend einen Schritt des Bestrahlens der auf das Drucksubstrat übertragenen Druckfarbe mit einem aktiven Energiestrahl.

11. Verfahren zur Herstellung eines bedruckten Materials nach Anspruch 10, umfassend das Bestrahlen des Drucksubstrats mit ultraviolettem Licht,
wobei die lithografische Druckplatte die farbabweisende Schicht auf einem Substrat umfasst, die in der farbabweisenden Schicht enthaltene farbabweisende Flüssigkeit eine Oberflächenspannung von 30 mN/m oder weniger aufweist und die Druckfarbe von 10 Masse-% bis 50 Masse-% einer lichtempfindlichen Komponente enthält.

12. Verfahren zur Herstellung eines bedruckten Materials nach Anspruch 11, wobei die Flüssigkeit ein Silikonmaterial ist.

13. Verfahren zur Herstellung eines bedruckten Materials nach Anspruch 11 oder 12, wobei die farbabweisende Schicht 10 Masse-% bis 25 Masse-% der Flüssigkeit enthält.

14. Verfahren zur Herstellung eines Druckerzeugnisses nach einem der Ansprüche 9 bis 13, wobei die Druckfarbe 0,5 Masse-% bis 15 Masse-% eines Acrylat Ester oder Methacrylatester enthält, der eine linearkettige Alkylgruppe aufweist.

## Revendications

1. Précurseur de plaque d'impression lithographique comprenant un substrat et au moins une couche thermosensible et une couche repoussant l'encre, dans lequel la couche repoussant l'encre, qui est une couche de caoutchouc de silicone, contient un liquide repoussant l'encre, le liquide repoussant l'encre ayant un point d'ébullition non inférieur à 150 °C à 101,3 kPa (1 pression atmosphérique), dans lequel la couche repoussant l'encre contient le liquide en une quantité de 10 % en masse à 30 % en masse.

2. Précurseur de plaque d'impression lithographique selon la revendication 1, dans lequel le liquide a une tension superficielle de 15 mN/m à 30 mN/m à 25 °C.

3. Précurseur de plaque d'impression lithographique selon la revendication 1 ou 2, dans lequel la couche thermosensible contient une résine novolaque.

4. Précurseur de plaque d'impression lithographique selon la revendication 3, dans lequel la couche thermosensible contient de 20 % en masse à 95 % en masse de la résine novolaque.

5. Précurseur de plaque d'impression lithographique selon la revendication 3 ou 4, dans lequel la couche thermosensible contient un composé complexe organique.

6. Précurseur de plaque d'impression lithographique selon la revendication 5, dans lequel la couche thermosensible contient la résine novolaque et le composé complexe organique en un rapport de masse de 2 à 6.

7. Précurseur de plaque d'impression lithographique selon l'une quelconque des revendications 1 à 7, qui présente un module d'élasticité de la surface de plaque de 4 MPa à 12 MPa lorsqu'une charge de 1 400 N/m² est appliquée à sa surface.

8. Procédé pour la production d'une plaque d'impression lithographique, comprenant les étapes consistant à :
exposer le précurseur de plaque d'impression lithographique selon l'une quelconque des revendications 1 à 7 à de la lumière conformément à une image ; et
développer le précurseur de plaque d'impression lithographique exposé pour éliminer la couche repoussant l'encre.

9. Procédé pour la production d'un matériel imprimé, comprenant les étapes consistant à :
permettre à une encre d'adhérer à la surface de la plaque d'impression lithographique obtenue selon la revendication 8 ; et
transférer l'encre directement ou par l'intermédiaire d'un blanchet sur un support d'impression.

10. Procédé pour la production d'un matériel imprimé selon la revendication 9, comprenant en outre une étape consistant à irradier l'encre transférée sur le support d'impression avec un rayonnement d'énergie active.

11. Procédé pour la production d'un matériel imprimé selon la revendication 10, comprenant l'irradiation du support d'impression avec de la lumière ultraviolette,
dans lequel la plaque d'impression lithographique comprend la couche repoussant l'encre sur un substrat, le liquide repoussant l'encre contenu dans la couche repoussant l'encre a une tension superficielle de 30 mN/m ou moins, et l'encre contient de 10 % en masse à 50 % en masse d'un composant photosensible.

12. Procédé pour la production d'un matériel imprimé selon la revendication 11, dans lequel le liquide est une matière en silicone.

13. Procédé pour la production d'un matériel imprimé selon la revendication 11 ou 12, dans lequel la couche repoussant l'encre contient de 10 % en masse à 25 % en masse du liquide.

14. Procédé pour la production d'un matériel imprimé selon l'une quelconque des revendications 9 à 13, dans lequel l'encre contient de 0,5 % en masse à 15 % en masse d'un ester d'acrylate ou de méthacrylate ayant un groupe alkyle à chaîne linéaire.
